# FASCICULE DE BREVET EUROPEEN

(11) **EP 0 842 538 B1**
(45) Date de publication et mention de la délivrance du brevet: **12.09.2001**
(21) Numéro de dépôt: 96925800.3
(22) Date de dépôt: 17.07.1996
(51) Int. Cl.: H01L 27/12, G02F 1/136, H01L 21/84

(54) **PROCEDE DE FABRICATION D'UNE MATRICE ACTIVE POUR ECRAN PLAT**
VERFAHREN ZUR HERSTELLUNG EINER AKTIVMATRIX FÜR EINEN FLACHBILDSCHIRM
METHOD FOR MAKING A FLAT SCREEN ACTIVE MATRIX

(30) Priorité: 28.07.1995 FR 9509262
(43) Date de publication de la demande: 20.05.1998
(73) Titulaire: THOMSON-LCD, 75008 Paris (FR)
(72) Inventeur: TEMPLIER, François, F-92050 Paris-La Défense Cédex (FR); SZYDLO, Nicolas, F-92050 Paris-La Défense Cédex (FR)
(74) Mandataire: Ruellan-Lemonnier, Brigitte
(86) Numéro de dépôt international: FR9601112
(87) Numéro de publication internationale: WO9705656

(56) Documents cités:
- EP-A- 0 376 437
- US-A- 5 396 084

## Description

La présente invention concerne un procédé de fabrication d'une matrice active pour écran plat, plus particulièrement un procédé de fabrication à six niveaux de masquage d'une matrice active pour écran à cristaux liquides dont les transistors de commande sont du type grille dessous.

Les écrans à cristaux liquides du type à matrice active sont, de manière connue, constitués d'une première plaque transparente comportant une contre-électrode et d'une deuxième plaque transparente comportant la matrice active proprement dite. Les deux plaques sont maintenues l'une contre l'autre par une câle d'épaisseur de manière à renfermer le cristal liquide. La matrice active proprement dite est donc constituée d'une mosaïque d'électrodes formant, avec la contre-électrode, un élément d'image ou pixel. Chaque pixel est relié à un réseau croisé de lignes et de colonnes par l'intermédiaire d'un transistor qui peut être, selon l'utilisation choisie, du type grille dessous (voir par exemple le document EP-A-0 376 437) ou du type grille dessus (voir par exemple le document US-A-5 396 084). Le transistor est un transistor en couche mince ou transistor TFT pour Thin Film Transistor en langue anglaise. Dans ce cas, les lignes sont connectées aux grilles des transistors tandis que la source et le drain sont reliés à la colonne et à l'électrode de pixel. Les écrans à cristaux liquides de ce type sont particulièrement adaptés pour des utilisations dans des systèmes de visualisation à vision directe ou à projection. Ainsi, les lignes reliées aux grilles des transistors forment des lignes de sélection et sont commandées par des circuits de commande périphériques qui les balayent les unes après les autres de manière à rendre passant les transistors, en permettant par les lignes de données ou colonnes connectées aux autres circuits de commande périphériques, de polariser les électrodes et de modifier les propriétés optiques du cristal liquide compris entre ces électrodes et la contre-électrode permettant ainsi la formation d'images sur l'écran.

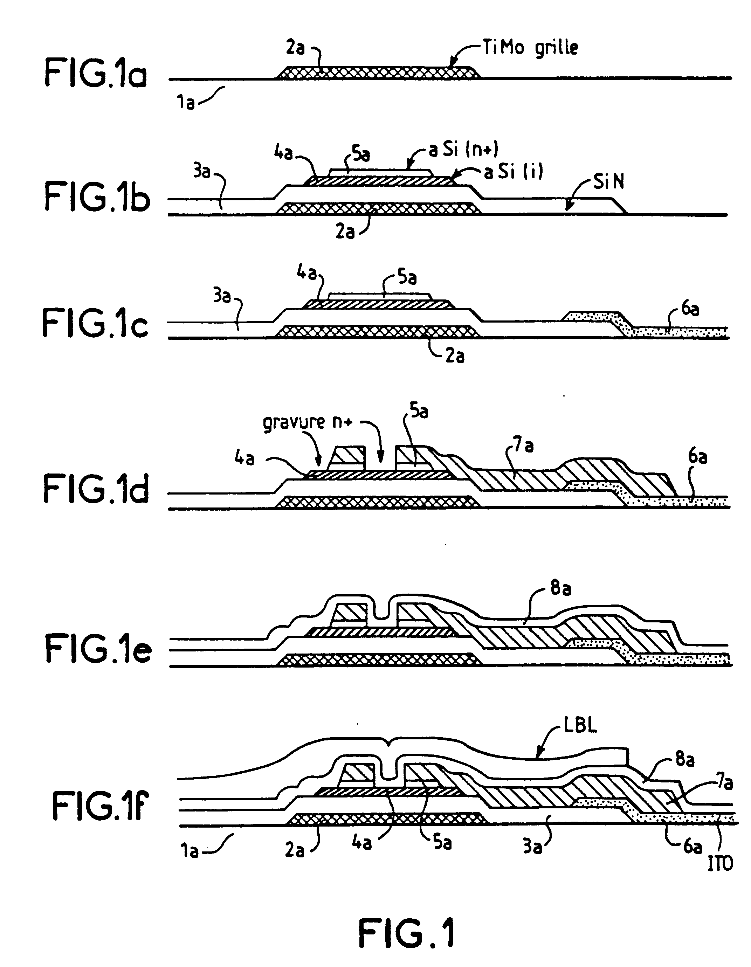

Pour les écrans à cristaux liquides utilisés en vision directe, la matrice active est une matrice dont les transistors de commande sont du type grille dessous. Cette matrice est en général réalisée en utilisant un procédé de fabrication à six niveaux de masquage. Ce procédé comporte, comme représenté sur les figures 1a à 1f, les étapes suivantes. Tout d'abord, on réalise, de manière connue, le dépôt et la gravure sur une plaque transparente 1a, généralement en verre, d'un premier niveau conducteur 2a constitué par exemple d'une double couche titane-molybdène, de manière à définir les lignes de sélection et les grilles des transistors, comme représenté sur la figure 1a. Cette étape constitue le premier niveau de masquage. Ensuite, comme représenté sur la figure 1b, on réalise le dépôt d'une triple couche: isolant de grille 3a, en nitrure de silicium par exemple, matériau semiconducteur 4a en silicium amorphe intrinsèque par exemple, et couche de contact ohmique 5a en silicium amorphe dopé n+ par exemple. On réalise ensuite de manière connue, la photogravure des couches 4a et 5a de façon à définir le canal de chaque transistor TFT. Cette étape constitue le deuxième niveau de masquage. On réalise alors la photogravure de la couche isolante de manière à définir les contacts à la périphérie de l'écran et éventuellement à retirer la couche isolante 3a au niveau du pixel, comme représenté sur la figure 1b. Ceci constitue le troisième niveau de masquage. Puis, comme représenté sur la figure 1c, on dépose un matériau conducteur et transparent tel que l'oxyde d'étain et d'indium ITO et on le grave de manière à définir les pixels 6a. Ceci constitue le quatrième niveau de masquage. On dépose ensuite une couche d'un matériau conducteur 7a tel que du molybdène que l'on grave de manière connue pour définir les colonnes ainsi que les source et drain des transistors TFT. Ceci réalise un cinquième niveau de masque. Puis, comme représenté sur la figure 1d, on grave la couche de contact 5a restant au niveau des transistors en utilisant les sources et drains comme masque selon la technique du "Back Channel Etch". On dépose ensuite, comme représenté sur la figure 1e, une couche de passivation 8a en nitrure de silicium, par exemple, que l'on grave de manière à définir des contacts à la périphérie. Cette étape constitue la sixième étape de masquage. Eventuellement, et comme représenté sur la figure 1f, on peut déposer et graver une couche opaque isolante connue sous le terme anglais "Light Blocking Layer ou LBL" de manière à réaliser un masque optique au niveau de chaque transistor.

Le procédé décrit ci-dessus est largement utilisé pour réaliser des écrans à cristaux liquides. Toutefois, les écrans à cristaux liquides utilisés pour la vision directe sont soumis à plusieurs contraintes. Il faut d'une part minimiser les défauts pixels pour ces écrans dont la taille est beaucoup plus grande que la taille de ceux utilisés en projection. Ces défauts ont pour origine des courts-circuits colonne/pixel, ou des courts-circuits ligne/pixel. Pour minimiser ce type de défauts, il faut donc isoler le mieux possible d'une part le niveau des lignes et le niveau des électrodes de pixel, d'autre part le niveau des colonnes et le niveau des électrodes de pixel. L'autre contrainte importante pour ce type d'écrans est qu'il faut assurer une qualité cosmétique parfaite sur l'ensemble de l'écran, malgré les dimensions importantes. Pour cela, il faut supprimer les phénomènes de papillotements de "cross-talk" horizontal et vertical, mais aussi les défauts liés à l'utilisation de photorépéteurs tels que le défaut connu sous le terme "stepper pattern".

La présente invention a pour but de proposer un nouveau procédé de fabrication de la matrice active qui permet de résoudre, au moins en partie, les problèmes ci-dessus.

En conséquence, la présente invention a pour objet un procédé de fabrication d'une matrice active pour écran plat, la matrice active étant constituée d'une mosaïque d'électrodes formant un élément d'image ou pixel, relié chacun à un réseau croisé de lignes et de colonnes par l'intermédiaire d'un transistor du type grille dessous, les lignes étant connectées aux grilles des transistors tandis que la source et le drain sont reliés à la colonne et à l'électrode de pixel, comportant les étapes suivantes :
- dépôt et gravure sur une plaque isolante transparente d'un premier niveau conducteur permettant de définir les lignes de l'écran et les grilles des transistors ainsi que des motifs formant contact ;
- dépôt successif d'une tri-couche constituée d'un isolant de grille, d'un matériau semi-conducteur et d'une couche servant à réaliser un contact ohmique avec les sources et les drains ;
- gravure de la couche de contact ohmique et de la couche de matériau semi-conducteur de manière à n'en laisser qu'aux emplacements des transistors et aux croisements entre les lignes et les colonnes ;
- gravure de la couche d'isolant de grille de manière à définir des ouvertures au niveau des motifs ;
- dépôt d'un second niveau conducteur et gravure de ce niveau en vue de définir les colonnes de la matrice ainsi que les sources et drains des transistors ;
- gravure de la couche de contact ohmique en utilisant comme masque le second niveau conducteur ;
- dépôt d'un niveau isolant et gravure de ce niveau de manière à définir des ouvertures au niveau des motifs de contacts et
- dépôt et gravure d'un niveau conducteur et transparent afin de définir les électrodes de pixels.

Dans le procédé décrit ci-dessus, l'électrode de pixel est réalisée en dernier. Ce niveau est donc séparé du niveau conducteur source, drain, colonnes par un niveau isolant, le contact entre les deux niveaux conducteurs se faisant par l'intermédiaire des motifs réalisés au premier niveau de masquage. De ce fait, on obtient une meilleure isolation entre les niveaux qu'avec le procédé de l'art antérieur. Ceci a pour conséquence une diminution des risques de courts-circuits pixels/lignes et pixels/colonnes et donc une amélioration du rendement.

Selon une autre caractéristique de la présente invention, lors de la première étape, l'on grave dans le premier niveau conducteur, des lignes horizontales, parallèles aux lignes d'adressage qui servent à réaliser une capacité de stockage avec l'électrode de pixel réalisée ultérieurement.

D'autres caractéristiques et avantages de la présente invention apparaîtront à la lecture de la description faite ci-après avec référence aux dessins ci-annexés dans lesquels :
- les figures 1a à 1f, déjà décrites, représentent les principales étapes d'un procédé de réalisation d'une matrice active à six niveaux de masquage conforme à l'art antérieur ;
- les figures 2a à 2f représentent les principales étapes du procédé conforme à la présente invention ;
- la figure 3 représente une vue de dessus d'un pixel obtenu par le procédé des figures 2a à 2f, et
- la figure 4 est une vue très schématique d'un écran à cristaux liquides avec des filtres colorés, disposés en structure "Quad" et des circuits d'adressage.

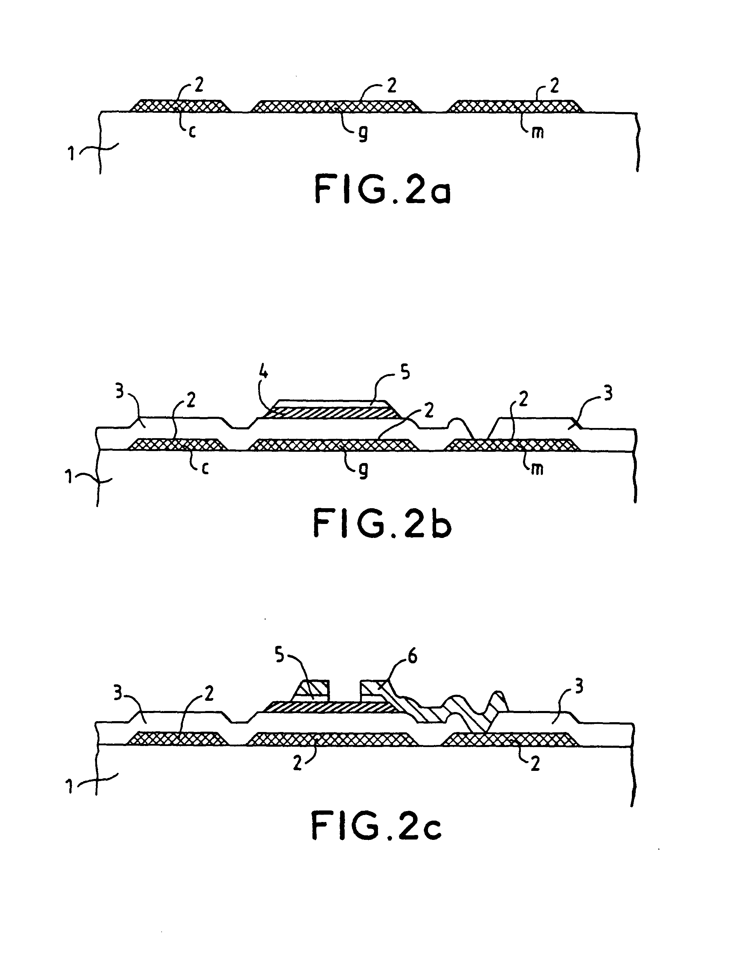

Comme représenté sur la figure 2a, les première et seconde étapes du procédé de fabrication consistent à développer puis à graver un niveau conducteur 2 constituant le premier niveau de masquage, par exemple une couche telle qu'une couche de molybdène, d'aluminium, de tungstène ou de chrome, ou une double couche avec du titane ou du chrome comme première couche d'adhérence sur une épaisseur de l'ordre de 100 à 200 nm, déposée par pulvérisation cathodique, sur le substrat transparent et isolant 1 qui peut être du verre. La gravure de cette couche est réalisée de manière à former, comme on peut le voir sur la figure 2a, les lignes d'adressage de la matrice et grilles des transistors g, des lignes conductrices c en vue de réaliser une capacité de stockage du pixel, ainsi que des motifs m utilisés ultérieurement pour le contact entre l'électrode de pixel et l'électrode du transistor TFT qui la commande.

La troisième étape du procédé, selon l'invention, consiste à déposer successivement trois couches. La première couche 3 est un isolant de grille, par exemple du nitrure de silicium ou de l'oxyde de silicium, déposé sur une épaisseur de l'ordre de 200 à 400 nm. La seconde couche 4 est un semi-conducteur, par exemple du silicium amorphe non dopé, déposé sur une épaisseur de l'ordre de 100 à 300 nm. La troisième couche 5, d'une épaisseur de 10 à 80 nm, qui peut être du silicium dopé amorphe ou microcristallin, sert à réaliser un contact ohmique avec les sources et drains qui seront déposés ultérieurement.

La quatrième étape du procédé selon l'invention consiste à graver les couches 4 et 5 pour en laisser uniquement aux zones d'emplacement des transistors TFT, comme on peut le voir sur la figure 2b, ainsi qu'aux intersections (non représentés) entre les lignes, à savoir les lignes d'adressage et les lignes de stockage et colonnes, afin de réduire les risques de court-circuit. Cette étape constitue un deuxième niveau de masquage.

La cinquième étape du procédé selon l'invention consiste à graver la couche 3, de manière à ouvrir des contacts au niveau de la périphérie (non représenté) mais aussi dans la matrice au niveau des motifs m, comme on le voit sur la figure 2b. Ceci constitue la troisième étape de masquage.

Les sixième et septième étapes du procédé selon l'invention consistent à déposer, puis à graver une couche conductrice 6, par exemple une couche métallique comme du molybdène ou de l'aluminium, ou une double couche de chrome plus aluminium ou molybdène plus aluminium, sur une épaisseur de l'ordre de 100 à 500 nm, déposée par pulvérisation cathodique de manière à réaliser les colonnes, les sources et les drains de la matrice, comme on peut le voir sur la figure 2c. Cette étape est la quatrième étape de masquage.

La huitième étape du procédé selon l'invention consiste à graver le restant de la couche conductrice 5 restant au niveau du transistor TFT entre la source et le drain, selon le procédé auto-aligné connu sous la dénomination "gravure du canal arrière" ("Back Channel Etch" en langue anglaise) qui consiste à utiliser comme masque, la couche 6 précédemment définie, de manière à ne laisser la couche 5 qu'au niveau des contacts sources et drains (figure 2c).

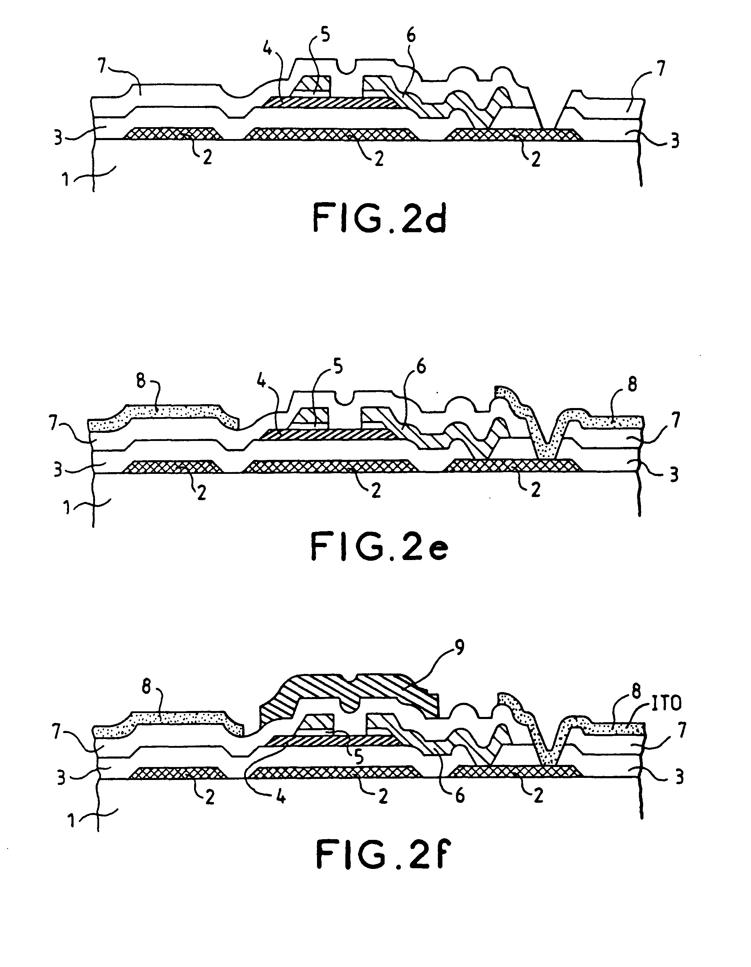

La neuvième étape du procédé selon l'invention consiste à déposer une couche isolante 7, sur une épaisseur de l'ordre de 100 à 500 nm, comme on peut le voir sur la figure 2d. Cette couche permet d'améliorer l'isolation entre les lignes et les électrodes de pixel, et entre les colonnes et les électrodes de pixels, d'où une diminution des courts-circuits et donc une amélioration des rendements de fabrication.

La dixième étape du procédé selon l'invention consiste à graver, ce qui constitue une cinquième étape de masquage, successivement la couche isolante 7 puis la couche isolante de grille 3, de manière à créer une ouverture jusqu'au niveau du premier niveau conducteur 2. Cette ouverture se fait dans la matrice, au niveau de la zone de contact comme on peut le voir sur la figure 2d mais aussi en périphérie (non représenté).

Les onzième et douzième étapes du procédé selon l'invention consistent à déposer une couche conductrice et transparente 8, par exemple de l'oxyde d'indium et d'étain (ITO) par pulvérisation cathodique, sur une épaisseur de l'ordre de 30 à 150 nm, puis à la graver, ce qui constitue une sixième étape de masquage, de préférence par voie liquide, de manière à définir les électrodes de pixels, comme on peut le voir sur la figure 2e.

Chaque électrode de pixel est alors reliée électriquement à l'électrode du transistor TFT qui la commande par le biais d'un contact, défini lors de la douzième étape entre l'électrode de pixel 8 et le premier niveau conducteur 2, puis par un contact défini lors de la cinquième étape entre ce niveau conducteur 2 et le niveau conducteur 6. L'intérêt de réaliser le contact entre l'électrode de pixel et l'électrode du transistor TFT qui la commande par cette technique plutôt que de réaliser un contact direct entre ces deux niveaux à travers la couche 3, se justifie par la contrainte suivante.

La couche conductrice 6, utilisée notamment pour définir les colonnes de l'écran, doit offrir une résistance carrée la plus faible possible. Un moyen pour répondre à cette exigence est d'utiliser une assez forte épaisseur pour cette couche. Un des risques si on utilise par exemple du molybdène sur une épaisseur de 400 nm et que l'on grave cette couche par voie liquide est que le passage de cette marche est difficile à franchir pour les couches déposées ultérieurement, comme la couche isolante 7 et la couche conductrice et transparente 8. Ceci a pour conséquence, par exemple, que la continuité de la couche 8 ne soit pas assurée entre le bas et le haut d'une marche de la couche 6. Dans ce cas, il n'est pas envisageable de réaliser un contact direct, à travers la couche isolante 7 entre la couche 8 et la couche 6.

La treizième étape du procédé selon l'invention consiste à déposer, puis à graver une couche opaque isolante 9, de manière à réaliser, comme on peut le voir sur la figure 2f, un masque optique au niveau de chaque transistor TFT, afin de le protéger de la lumière venant par le dessus et limiter les problèmes de photoconductivité du matériau semi-conducteur 4, et de manière à réaliser un espaceur entre les deux électrodes constituant l'écran à cristaux liquides. La couche 9 peut être, par exemple, une couche organique opaque, déposée à la tournette sur une épaisseur de l'ordre de quelques micromètres.

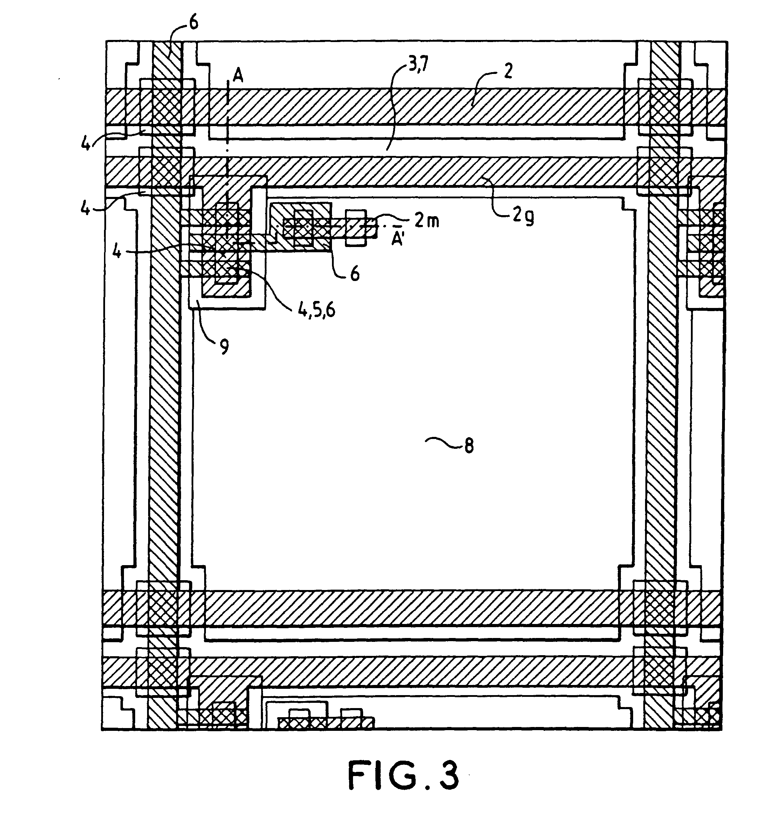

La figure 3 représente une vue planaire d'un pixel obtenu grâce au procédé selon l'invention. Les références correspondant aux différents niveaux de matériau des figures 2a à 2f ont été conservés. En effet, la figure 2f correspond à une coupe selon AA' sur la figure 3.

Le dessin du transistor de commande, selon la présente invention, est tel que le doigt de matériau 6 correspondant à l'électrode du transistor qui commande le pixel déborde largement au-delà des limites de la grille, définie lors de la gravure du niveau conducteur 1. Cela permet de maintenir le couplage capacitif ligne/pixel indépendamment des possibles décalages d'alignement entre le niveau conducteur 1 et le niveau conducteur 6.

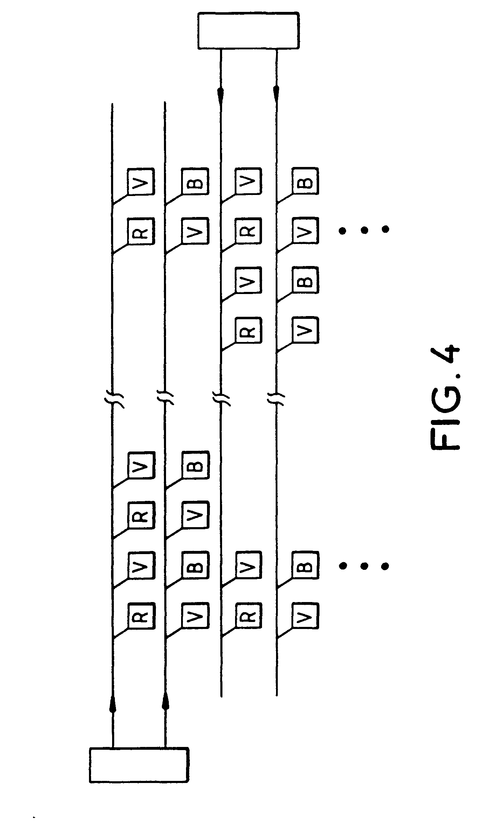

Selon un mode de réalisation particulier, la plaque ainsi réalisée est assemblée avec une contre électrode comportant des filtres colorés en structure de type "Quad" comme on peut le voir sur la figure 4. Une structure "Quad" est constituée, par exemple, d'une matrice dont les lignes impaires sont constituées d'une succession de pixels dont les colorants sont alternativement rouge (R) et vert (V), et les lignes impaires alternativement vert (V) et bleu (B). Lorsqu'une ligne est sélectionnée, l'impulsion d'adressage qui la parcourt est déformée entre le début et la fin de la ligne, étant donné l'impédance de cette ligne. De ce fait, sur une ligne donnée, et pour un même niveau de tension vidéo amené sur les colonnes, il y aura une variation de la réponse électro-optique entre le début et la fin de la ligne avec pour conséquence que la ligne sera plus sombre en début, et plus claire en fin. Dans le cas d'un adressage classique, par exemple en sélectionnant alternativement une ligne par la gauche de l'écran et une ligne par la droite, les lignes impaires comportant les colorants R G R G seront systématiquement plus sombre à gauche et les lignes paires à colorant V B V B seront systématiquement plus claires à droite, d'où une dominante bleu à gauche et rouge à droite. Afin de supprimer ce genre d'effet, la présente invention propose un adressage des lignes deux à deux, alternativement à gauche et à droite de l'écran, comme on peut le voir sur la figure 4. De ce fait, les effets décrits plus haut sont moyennés deux à deux et ne sont plus visibles à la distance d'observation usuelle de l'écran.

La présente invention s'applique à tous les écrans à cristaux liquides dont la matrice active est constituée de transistors dits grille dessous, mais plus particulièrement à ceux utilisés dans des systèmes à vision directe.

## Revendications

1. Procédé de fabrication d'une matrice active pour écran plat, la matrice active étant constituée d'une mosaïque d'électrodes formant un élément d'image ou pixel, relié chacun à un réseau croisé de lignes et de colonnes par l'intermédiaire d'un transistor du type grille dessous, les lignes étant connectées aux grilles des transistors tandis que la source et le drain sont reliés à la colonne et à l'électrode de pixel, comportant les étapes suivantes :
- dépôt et gravure sur une plaque (1) isolante transparente d'un premier niveau (2) conducteur permettant de définir les lignes de l'écran et les grilles (9) des transistors ainsi que des motifs (m) formant contact ;
- dépôt successif d'une tri-couche constituée d'un isolant de grille (3), d'un matériau semi-conducteur (4) et d'une couche (5) servant à réaliser un contact ohmique avec les sources et les drains ;
- gravure de la couche (5) de contact ohmique et de la couche (4) de matériau semi-conducteur de manière à n'en laisser qu'aux emplacements des transistors et aux croisements entre les lignes et les colonnes ;
- gravure de la couche (3) d'isolant de grille de manière à définir des ouvertures au niveau des motifs (m) ;
- dépôt d'un second niveau conducteur (6) et gravure de ce niveau en vue de définir les colonnes de la matrice ainsi que les sources et drains des transistors ;
- gravure de la couche (5) de contact ohmique en utilisant comme masque le second niveau conducteur (6);
- dépôt d'un niveau isolant (7) et gravure de ce niveau de manière à définir des ouvertures au niveau des motifs (m) et
- dépôt et gravure d'un niveau conducteur et transparent (8) afin de définir les électrodes de pixels.

2. Procédé selon la revendication 1, **caractérisé en ce qu'**il comporte une étape supplémentaire consistant à déposer et à graver une couche opaque et isolante (9) en vue de masquer les transistors à la lumière et de réaliser un espaceur entre les deux électrodes formant l'écran.

3. Procédé selon l'une quelconque des revendications 1 et 2, **caractérisé en ce que** lors de la première étape l'on grave dans le premier niveau conducteur des électrodes de capacité de stockage (c) parallèles aux lignes d'adressage.

4. Procédé selon l'une quelconque des revendications 1 à 3, **caractérisé en ce que** les premier et second niveaux conducteurs sont réalisés par une couche ou une double couche d'un matériau métallique tel que l'aluminium, le chrome, le titane, le molybdène, le tungstène.

5. Procédé selon la revendication 4, **caractérisé en ce que** le premier niveau conducteur est constitué par une double couche métallique avec du titane ou du chrome comme première couche.

6. Procédé selon la revendication 4, **caractérisé en ce que** le second niveau conducteur est constitué par une double couche métallique en chrome plus aluminium ou en molybdène plus aluminium.

7. Procédé selon l'une quelconque des revendications 1 à 6, **caractérisé en ce que** le matériau isolant utilisé pour l'isolant de grille est choisi parmi le nitrure de silicium ou l'oxyde de silicium.

8. Procédé selon l'une quelconque des revendications 1 à 7, **caractérisé en ce que** le matériau semi-conducteur est choisi parmi le silicium amorphe dopé ou non dopé, le silicium micro-cristallin.

9. Procédé selon l'une quelconque des revendications 1 à 8, **caractérisé en ce que** le niveau conducteur et transparent est réalisé en oxyde d'indium et d'étain (ITO) ou en oxyde d'étain.

10. Procédé selon l'une quelconque des revendications 1 à 9, **caractérisé en ce que** la gravure de la couche en matériau du second niveau conducteur (6) correspondant à l'électrode du transistor qui commande l'électrode de pixel a un dessin en forme de doigt tel qu'il déborde les limites de la grille.

## Patentansprüche

1. Verfahren zur Herstellung einer Aktivmatrix für einen flachen Bildschirm, wobei die Aktivmatrix aus einem Mosaik von Elektroden besteht, die ein Bildelement oder ein Pixel bilden und jede mit einem gekreuzten Netzwerk aus Reihen und Spalten durch einen Transistor vom Typ mit unten liegendem Gate die Reihen mit den Gates der Transistoren verbunden sind, während die Source und das Drain mit der Spalte und der Pixelelektrode verbunden sind, mit folgenden Schritten:
- Aufbringung und Ätzung einer ersten Leitschicht (2) auf einer transparenten Isolierplatte (1) zur Bildung der Reihen des Schirms und der Gates (9) der Transistoren sowie von Kontakt-bildenden Mustern (m),
- darauffolgende Aufbringung einer Dreifachschicht aus einem Isoliergate (3), einem Halbleitermaterial (4) und einer Schicht (5), die zur Herstellung eines ohmschen Kontaktes mit den Sourcen und den Drains dient,
- Ätzen der ohmschen Kontaktschicht (5) und der Schicht (4) aus einem Halbleitermaterial derart, daß nur die Lagen der Transistoren und der Kreuzungen zwischen den Reihen und den Spalten verbleiben,
- Ätzen der Gate-Isolierschicht (3) derart, daß Öffnungen bei den Mustern (m) gebildet werden,- Aufbringung einer zweiten Leitschicht (6) und Ätzen dieser Schicht, derart, daß Spalten der Matrix sowie die Sourcen und Drains der Transistoren gebildet werden,
- Ätzen der ohmschen Kontaktschicht (5) unter Verwendung der zweiten Leiterschicht (6) als Maske,
- Aufbringung einer Isolierschicht (7) und Ätzen dieser Schicht derart, daß Öffnungen bei den Mustern (m) gebildet werden, und
- Aufbringung und Ätzen einer leitenden und transparenten Schicht (8), um die Pixelelektroden zu bilden.

2. Verfahren nach Anspruch 1, **dadurch gekennzeichnet, daß** es einen zusätzlichen Schritt enthält, der darin besteht, daß eine opake Isolierschicht (9) zur Maskierung der Transistoren gegenüber Licht und zur Bildung eines Zwischenraums zwischen den beiden den Schirm bildenden Elektroden aufgebracht und geätzt wird.

3. Verfahren nach einem der Ansprüche 1 und 2, **dadurch gekennzeichnet, daß** während des ersten Schritts Leiter für Elektroden der Speicherkapazität (c) parallel zu den Adressierleitungen in der ersten Leitschicht geätzt werden.

4. Verfahren nach einem der Ansprüche 1 bis 3, **dadurch gekennzeichnet, daß** die erste und die zweite Leitschicht durch eine Schicht oder eine doppelte Schicht aus einem metallischen Material gebildet sind, wie Aluminium, Chrom, Titan, Molybdän, Wolfram.

5. Verfahren nach Anspruch 4, **dadurch gekennzeichnet, daß** die erste Leitschicht aus einer doppelten Metallschicht mit Titan oder Chrom als erste Schicht gebildet ist.

6. Verfahren nach Anspruch 4, **dadurch gekennzeichnet, daß** die zweite Metallschicht durch eine doppelte Metallschicht aus Chrom plus Aluminium oder aus Molybdän plus Aluminium gebildet ist.

7. Verfahren nach einem der Ansprüche 1 bis 6, **dadurch gekennzeichnet, daß** das Isoliermaterial, das für die Isolierung des Gate dient, aus einem Siliziumnitrid oder Siliziumoxid ausgewählt ist.

8. Verfahren nach einem der vorangehenden Ansprüche 1 bis 7, **dadurch gekennzeichnet, daß** das Halbleitermaterial unter einem dotierten oder nicht-dotierten amorphen Silizium und einem mikrokristallienen Silizium ausgewählt ist.

9. Verfahren nach einem der vorangehenden Ansprüche 1 bis 8, **dadurch gekennzeichnet, daß** die leitende und transparente Schicht aus einem Indium-Zinn-Oxyd (ITO) oder einem Zinnoxyd besteht.

10. Verfahren nach einem der vorangehenden Ansprüche 1 bis 9, **dadurch gekennzeichnet, daß** das Ätzen der Schicht aus einem Material der zweiten leitenden Ebene (6), die der Elektrode des Transistors entspricht, der die Pixelelektrode steuert, die Form eines Fingers hat, derart, daß sie sich über die Begrenzungen des Gate hinaus erstreckt.

## Claims

1. Process for fabricating an active matrix for a flat screen, the active matrix consisting of a mosaic of electrodes forming a picture element, or pixel, each being connected to a crossed network of rows and columns by means of a transistor of the bottom gate type, the rows being connected to the gates of the transistors while the source and the drain are connected to the column and to the pixel electrode, including the following steps:
- depositing and etching, on a transparent insulating plate (1), a first conductor level (2) for defining the rows of the screen and the gates (9) of the transistors as well as contact-forming features (m);
- successively depositing a triple layer consisting of a gate insulator (3), a semiconductor material (4) and a layer (5) used to make an ohmic contact with the sources and the drains;
- etching the ohmic contact layer (5) and the layer (4) of semiconductor material so as not to leave any thereof except at the locations of the transistors and the crossings between the rows and the columns;
- etching the gate insulator layer (3) so as to define apertures in the features (m);
- depositing a second conductor level (6) and etching this level with a view to defining the columns of the matrix as well as the sources and drains of the transistors;
- etching the ohmic contact layer (5) by using the second conductor level (6) as a mask;
- depositing an insulator level (7) and etching this level so as to define apertures in the features (m); and
- depositing and etching a transparent conductor level (8) in order to define the pixel electrodes.

2. Process according to Claim 1, **characterized in that** it includes an additional step consisting in depositing and etching an opaque insulating layer (9) with a view to masking the transistors from light and to producing a spacer between the two electrodes forming the screen.

3. Process according to either one of Claims 1 and 2, **characterized in that**, during the first step, storage capacitor electrodes (c) parallel to the address lines are etched in the first conductor level.

4. Process according to any one of Claims 1 to 3, **characterized in that** the first and second conductor levels are produced by a layer or a double layer of a metallic material such as aluminium, chromium, titanium, molybdenum, tungsten.

5. Process according to Claim 4, **characterized in that** the first conductor level consists of a double metallic layer with titanium or chromium as first layer.

6. Process according to Claim 4, **characterized in that** the second conductor level consists of a double metallic layer of chromium plus aluminium or of molybdenum plus aluminium.

7. Process according to any one of Claims 1 to 6, **characterized in that** the insulating material used for the gate insulator is chosen from silicon nitride or silicon oxide.

8. Process according to any one of Claims 1 to 7, **characterized in that** the semiconductor material is chosen from amorphous silicon, doped or undoped, and microcrystalline silicon.

9. Process according to any one of Claims 1 to 8, **characterized in that** the transparent conductor level is made of indium tin oxide (ITO) or of tin oxide.

10. Process according to any one of Claims 1 to 9, **characterized in that** the etching of the layer of material of the second conductor level (6) corresponding to the electrode of the transistor which controls the pixel electrode has a design in the shape of a finger such that it extends beyond the boundaries of the gate.
